# EUROPÄISCHE PATENTSCHRIFT

(11) **EP 1 525 391 B1**
(45) Veröffentlichungstag und Bekanntmachung des Hinweises auf die Patenterteilung: **16.09.2009**
(21) Anmeldenummer: 03787588.7
(22) Anmeldetag: 06.06.2003
(51) Int. Cl.: F02M 59/46, F02M 51/06, F02M 61/16

(54) **PIEZOELEKTRISCHES AKTORMODUL UND VERFAHREN ZUR MONTAGE EINES PIEZOELEKTRISCHEN AKTORMODULS**
PIEZOELECTRIC ACTUATOR MODULE AND METHOD FOR ASSEMBLING A PIEZOELECTRIC ACTUATOR MODULE
MODULE ACTIONNEUR PIEZOELECTRIQUE ET PROCEDE D'ASSEMBLAGE D'UN MODULE ACTIONNEUR PIEZOELECTRIQUE

(30) Priorität: 20.07.2002 DE 10233100
(43) Veröffentlichungstag der Anmeldung: 27.04.2005
(73) Patentinhaber: ROBERT BOSCH GMBH, 70442 Stuttgart (DE)
(72) Erfinder: KIENZLER, Dieter, 71229 Leonberg (DE); UHLMANN, Dietmar, 71404 Korb (DE); LOUTRAGE, Jean-Luc, 70469 Stuttgart (DE)
(86) Internationale Anmeldenummer: PCT/DE2003/001885
(87) Internationale Veröffentlichungsnummer: WO 2004/016939

(56) Entgegenhaltungen:
- WO-A-00/71885
- WO-A-98/15018
- DE-A- 10 016 247
- DE-A- 19 803 910
- DE-A- 19 909 106
- DE-A- 19 928 916
- DE-C- 19 857 615
- DE-C- 19 921 242
- US-A- 5 031 841
- US-B1- 6 333 586

## Beschreibung

### Stand der Technik

Die Erfindung geht von einem piezoelektrischen Aktormodul, insbesondere für einen Injektor im Hochdruckteil einer Einspritzanlage mit dem Speichereinspritzsystem "Common Rail" eines Kraftfahrzeuges, gemäß der im Oberbegriff des Patentanspruches 1 näher definierten Art sowie von einem Verfahren zur Montage eines Aktormoduls gemäß der im Oberbegriff des Patentanspruches 6 näher definierten Art aus.

Ein derartiges Aktormodul ist aus der Praxis bekannt und kann insbesondere in Verbindung mit Common-Rail-Speichereinspritzsystemen für Dieselverbrennungsmaschinen eingesetzt werden. Dabei ist das piezoelektrische Aktormodul einem ventilartig ausgebildeten Ventilsteuermodul zugeordnet und dient zur Betätigung eines Ventilschließgliedes des Ventilsteuermoduls. Mittels des Ventilsteuermoduls ist wiederum eine Düsennadel eines Düsenmoduls des Einspritzventils betätigbar. Die Düsennadel wirkt mit mindestens einer zu einem Verbrennungsraum der Verbrennungsmaschine führenden Einspritzöffnung zusammen.

Das piezoelektrische Aktormodul umfaßt üblicherweise einen Aktorfuß, der sich an einem Gehäuse des Einspritzventils abstützt, ein piezoelektrisches Bauelement, das beim Anlegen einer elektrischen Spannung eine Längung erfährt, sowie einen Aktorkopf, über den die Längung des piezoelektrischen Bauelements derart auf einen sogenannten Stellkolben übertragen wird, daß dieser axial verschoben wird. Der Stellkolben wirkt über einen als Hydraulikkammer ausgebildeten hydraulischen Koppler mit einem sogenannten Betätigungskolben zusammen, der wiederum mit dem Ventilschließglied verbunden ist. Ein solcher Aufbau wird auch in der DE 199 46 831 beschrieben.

Die DE 100 43 626 oder DE 19 921 242 zeigen ein piezoelektrisches Aktormodul, das von einer sich in axialer Richtung erstreckenden Hülse umgeben ist, welche zum Schutz des piezoelektrischen Bauelements vor Schmutz und Kraftstoff sowie vor Beschädigungen bei der Montage dient. Im Bereich des Aktorkopfes ist das piezoelektrische Aktormodul mittels eines Faltenbalges gedichtet, welcher zum einen einen Aktorhub zuläßt und zum anderen einen negativen Temperaturausdehnungskoeffizienten des piezoelektrischen Bauelements ausgleichen kann.

Faltenbalge haben jedoch den Nachteil, daß sie einen relativ großen Bauraum beanspruchen und kostenintensive Bauteile darstellen.

### Vorteile der Erfindung

Das piezoelektrische Aktormodul nach der Erfindung mit den Merkmalen nach dem Patentanspruch 1 hat demgegenüber den Vorteil, daß die Membran äußerst niedrig baut und daher nur einen geringen Bauraum benötigt. Zudem sind die Kosten der Membran deutlich geringer als diejenigen eines Faltenbalgs.

Die Membran des piezoelektrischen Aktormoduls nach der Erfindung ist vorzugsweise derart ausgelegt, daß sie einer Verschiebung des Aktorkopfes von beispielsweise 40 µm, die durch eine Längung des piezoelektrischen Bauelements ausgelöst wird, folgen kann. Wenn die Membran das Aktormodul in axialer Richtung dichtet, so bildet sie zusammen mit der das Aktormodul radial begrenzenden Hülse eine schützende Ummantelung des Aktormoduls. Die Gesamtheit der Bauteile aus dem Aktorfuß, dem piezoelektrischem Bauelement, dem Aktorkopf, der Hülse und der Membran bildet somit eine Art piezoelektrische Aktorpatrone.

Die Membran hat somit folgende Funktionen, nämlich eine Dichtfunktion; eine Temperaturausgleichsfunktion zwischen dem piezoelektrischen Bauelement mit negativer Längenausdehnung und der Hülse mit positiver Längenausdehnung bei Erwärmung; sowie die Funktion der Übertragung des Aktorhubs (Verbindung Aktorkopf und Hülse).

Die Membran kann in einer vorteilhaften Ausführung beispielsweise aus einem Federstahl oder einem ausscheidungshärtenden Werkstoff gefertigt sein.

Eine besonders sichere Verbindung der Membran mit dem Aktorfuß kann erreicht werden, wenn diese beiden Bauteile miteinander verschweißt sind.

Des weiteren kann die Membran mit der Hülse verschweißt oder einstückig mit der Hülse gefertigt sein. In beiden Fällen weist die Membran vorteilhaft einen zentralen Durchbruch für einen verjüngten Bereich des Aktorfußes zur Übertragung der Längung des piezoelektrischen Bauelements auf den mindestens einen Kolben auf. Die Membran ist dann ringförmig ausgebildet.

Nach der Erfindung weist die Membran, die ringförmig ausgebildet ist, einen gewölbten Querschnitt auf. Bei dieser Ausführungsform sind die im Betrieb auf die Membran einwirkenden mechanischen Belastungen am geringsten.

Besonders vorteilhaft hinsichtlich des zur Verfügung stehenden Bauraums und der im Betrieb des Aktormoduls herrschenden Belastungen erweist es sich, eine Membran einzusetzen, die einen Querschnitt mit unterschiedlichen Krümmungsradien aufweist. Der Querschnitt einer derartige Membran ist beispielsweise im Bereich der Verbindung zu dem Aktorfuß eben ausgebildet, so daß die Membran in diesem Bereich konisch ausgebildet ist, wobei sich an den konischen Bereich zunächst ein Bereich mit einem ersten Krümmungsradius, an den Bereich mit dem ersten Krümmungsradius ein Bereich mit einem zweiten Krümmungsradius, der kleiner ist als der erste Krümmungsradius, und an den Bereich mit dem zweiten Krümmungsradius ein Bereich mit einem dritten Krümmungsradius, der wiederum kleiner ist als der zweite Krümmungsradius, anschließt. An den Bereich mit dem dritten Krümmungsradius kann sich wiederum ein parallel zu der Hülse ausgerichteter, zylindrischer Bereich anschließen, über den die Membran mit der Hülse verbunden ist. Der Winkel zwischen dem konischen Bereich und dem zylindrischen Bereich der Membran beträgt beispielsweise 45°. Bei einem Außendurchmesser der ringförmigen Membran von beispielsweise 9,85 mm und einem Innendurchmesser der ringförmigen Membran von beispielsweise 3,7 mm der erste Krümmungsradius 1,9 mm, der zweite Krümmungsradius 1,5 mm und der dritte Krümmungsradius 1,0 mm betragen. Eine derartige Membranform ist das Ergebnis einer FEM-Optimierung unter vorgegebenen Bauraumbedingungen. Diese Membranform mit einer Membrandicke von beispielsweise 80 µm ermöglicht es, die im Betrieb des Aktormoduls auftretenden Belastungen aufzunehmen, die insbesondere aus dem an der Membran auftretenden Fluiddruck von maximal 60 bar, Temperaturschwankungen zwischen -40 °C und 160 °C und einem Aktorhub von etwa 35 µm bestehen. Die Anbindung der Membran an den Aktorkopf bzw. an die Hülse erfolgt zweckmäßigerweise über Laserschweißnähte.

Die Dicke der Membran beträgt bei einer vorteilhaften Ausführung beispielsweise zwischen 70 µm und 0,2 mm.

Die Erfindung hat auch ein Verfahren zur Montage eines piezoelektrischen Aktormoduls zum Gegenstand, welches Aktormodul zumindest ein piezoelektrisches Bauelement, einen Aktorfuß und einen Aktorkopf umfaßt, welcher mit einem von dem piezoelektrischen Bauelement zu betätigenden Bauteil zusammenwirkt, wobei das Aktormodul von einer sich in axialer Richtung erstreckenden Hülse umgeben ist. Erfindungsgemäß wird die Hülse auf der Seite des Aktorfußes stirnseitig mittels einer Membran verschlossen, die sich im wesentlichen in radialer Richtung erstreckt.

Zweckmäßig wird die Membran beim Verschließen der Hülse lastfrei mit dem Aktorkopf verschweißt. Anschließend kann die Membran zusammen mit dem Aktorkopf in die Hülse eingeführt und das piezoelektrische Bauelement mit einer Vorlast beaufschlagt werden. Bei einer Aktorsteifigkeit von 40 N/µm entspricht eine Vorlast von 750 N einem Weg von etwa 19 µm. Die Membran selbst bleibt hierbei lastfrei. Anschließend wird die Membran bei belastetem, piezoelektrischem Bauelement mit der Hülse verschweißt, woraufhin die Vorlast von dem Aktorkopf weggenommen wird, was eine Auslenkung der Membran in Richtung des Aktorfußes um 19 µm bewirkt. Bei einem derartigen Montageverfahren wird aufgrund der 750 N Vorlast, die auf die Hülse wirken, die positive Auslenkung der Membran kompensiert. Die Membran befindet sich dann bei unbetätigtem piezoelektrischen Bauelement und ohne auf die Membran wirkendem Fluiddruck bei einer Temperatur von beispielsweise 20 °C in Null-Lage und ist dabei lastfrei.

Weitere Vorteile und vorteilhafte Weiterbildungen des Gegenstandes nach der Erfindung ergeben sich aus der Beschreibung, der Zeichnung und den Patentansprüchen.

### Zeichnung

Beispiele eines piezoelektrischen Aktormoduls sind in der Zeichnung schematisch vereinfacht dargestellt und werden in der nachfolgenden Beschreibung näher erläutert. Es zeigen
Figur 1 ein nicht erfindungsgemäßes Aktormodul, welches als Ansteuereinheit eines Einspritzventils dient, in einem vereinfachten Längsschnitt;
Figur 2 eine perspektivische Darstellung eines Ausschnitts eines Aktorkopfbereichs des Aktormoduls nach Figur 1;
Figur 3 ein nicht erfindungsgemäßes Aktormodul bei einem Einspritzventil in einer Figur 1 entsprechenden Darstellung;
Figur 4 ein nicht erfindungsgemäßes Aktormodul im Längsschnitt;
Figur 5 eine erste Ausführungsform eines piezoelektrischen Aktormoduls im Längsschnitt;
Figur 6 eine vergrößerte Darstellung des in Figur 5 gestrichelt umrandeten Bereichs VI; und
Figur 7 eine zweite Ausführungsform in einer Figur 6 entsprechenden Darstellung.

### Beschreibung der Ausführungsbeispiele

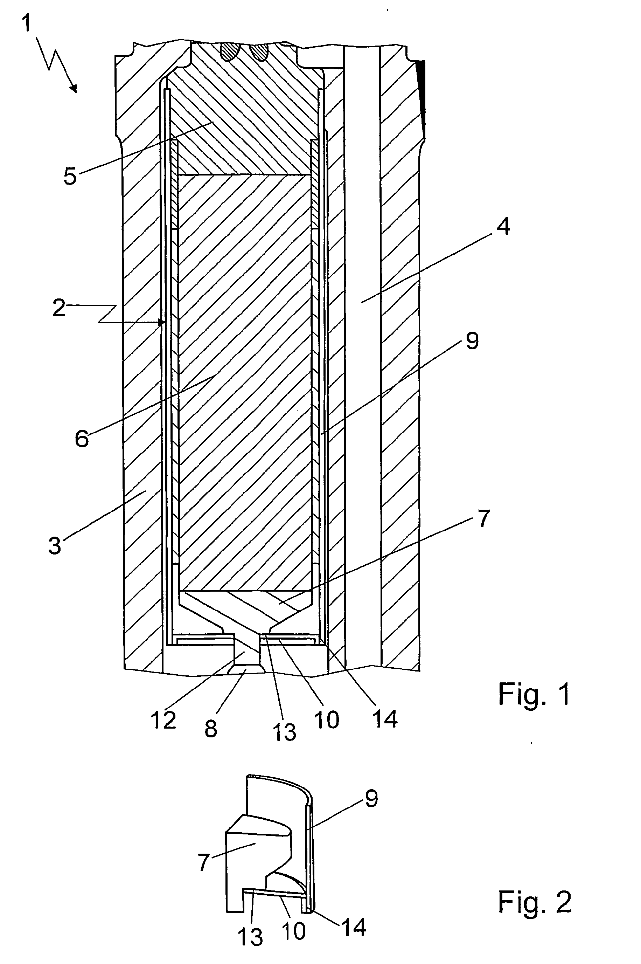

Das in den Figuren 1 und 2 dargestellte Beispiel, das nicht Teil des Erfindung ist, aber das Verständnis der Erfindung erleichtert, zeigt einen Teilbereich eines Kraftstoffeinspritzsystems 1, welches zum Einbau in eine Brennkraftmaschine eines Kraftfahrzeugs vorgesehen ist und hier als Common-Rail-Injektor zur Einspritzung von vorzugsweise Dieselkraftstoff ausgebildet ist.

Der Injektor umfaßt ein Aktormodul 2, das in einem Haltekörper 3 untergebracht ist und über ein Kopplermodul einem ventilartig ausgebildeten Ventilsteuermodul zugeordnet ist, das zur Betätigung einer Düsennadel dient, die in einem hier nicht näher dargestellten Düsenmodul angeordnet ist. In dem Haltekörper 3 ist des weiteren ein parallel zu dem Aktormodul 2 verlaufender Kraftstoffzufuhrkanal 4 (Hochdruckbohrung) ausgebildet, der zum Transport von Kraftstoff von einer Common-Rail-Speichereinheit zu dem Düsenmodul des Einspritzventils 1 dient.

Das Aktormodul 2 umfaßt einen sogenannten Aktorfuß 5, über den sich das Aktormodul 2 an dem Haltekörper 3 abstützt, ein sich an den Aktorfuß 5 in axialer Richtung anschließendes piezoelektrisches Bauelement 6, welches wie üblich aus einer Vielzahl von Schichten aus einem piezoelektrischen Werkstoff gefertigt ist, sowie einen sich an das piezoelektrische Bauelement 6 in der dem Aktorfuß 5 abgewandten Richtung anschließenden sogenannten Aktorkopf 7. Der Aktorkopf 7 dient zur Übertragung einer Längung bzw. Kontraktion des piezoelektrischen Bauelements 6 auf einen an sich bekannten, hier nicht dargestellten Stellkolben der Ventilsteuereinheit, welche im Prinzip vorzugsweise wie ein in der DE 199 46 831 beschriebenes Ventil zum Steuern von Flüssigkeiten aufgebaut ist.

So kann der Stellkolben in üblicher Weise über einen als Hydraulikkammer ausgebildeten, hydraulischen Koppler (Kopplermodul) mit einem sogenannten Betätigungskolben in Wirkverbindung stehen, wobei der untere Betätigungskolben vorzugsweise wiederum mit einem Ventilschließglied verbunden ist, das mit einem Ventilsitz zusammenwirkt.

Die Übertragung der Längung des piezoelektrischen Bauelements 6 erfolgt über eine hier als Ausgleichselement dienende Kugel 8. Die Kugel 8 hat beispielsweise einen Durchmesser von etwa 3 mm.

Das piezoelektrische Aktormodul 2 ist hier von einer sich in axialer Richtung erstreckenden, im wesentlichen zylinderförmig ausgebildeten, dünnwandigen Hülse 9 umgeben, die beispielsweise aus kostengünstigem rostfreiem Stahl gefertigt ist und das Aktormodul 2 radial dichtet.

An der dem Aktorfuß 5 abgewandten Seite ist das piezoelektrische Aktormodul 2 in axialer Richtung mittels einer vorliegend aus Federstahl gebildeten Membran 10 abgedichtet, welche sich im wesentlichen in radialer Richtung erstreckt, ringförmig ausgebildet ist und einen zentralen Durchbruch für einen zapfenförmigen Bereich 12 des Aktorkopfes 7 aufweist.

Die Membran hat beispielsweise eine Dicke von 0,08 mm bis 0,2 mm, einen Außendurchmesser von 9,5 mm und einen Innendurchmesser von 2,5 mm.

Die Membran 10, deren Formgebung hier im wesentlichen eben bzw. plattenartig ist, ist an der dem zapfenförmigen Bereich 12 zugewandten, inneren Begrenzung über eine Schweißnaht 13 mit dem Aktorkopf 7 fest verbunden. An der äußeren Begrenzung, die der Hülse 9 zugewandt ist, ist die Membran 10 über eine Schweißnaht 14 mit der Hülse 9 verbunden.

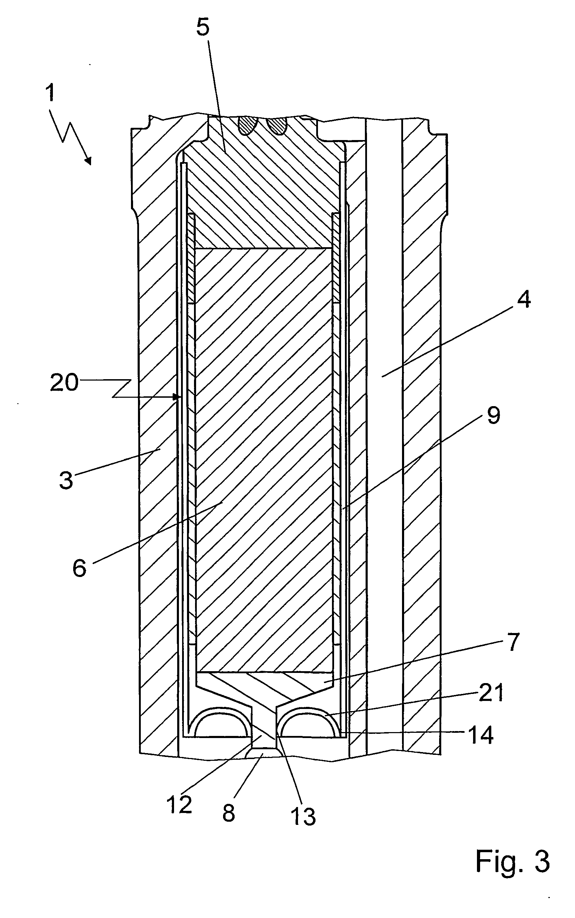

In Figur 3 ist ein alternatives Beispiel eines nicht erfindungsgemäßen piezoelektrischen Aktormoduls 20 dargestellt. Diese Ausführungsform unterscheidet sich von derjenigen nach den Figuren 1 und 2 durch eine Membran 21, welche elliptisch bis kreisbogenförmig gewölbt ist, wobei sich die Wölbung in Richtung des piezoelektrischen Bauelements 6 erstreckt. Die Membran 21; die sich im wesentlichen in radialer Richtung erstreckt, ist ebenfalls ringförmig ausgebildet und au der inneren Begrenzung über eine Schweißnaht 13 mit dem Aktorkopf 7 und an der äußeren Begrenzung über eine Schweißnaht 14 mit der Hülse 9 verbunden. Bei dieser Ausführungsform sind die mechanischen Belastungen, die im Betrieb auf die Membran einwirken, gering.

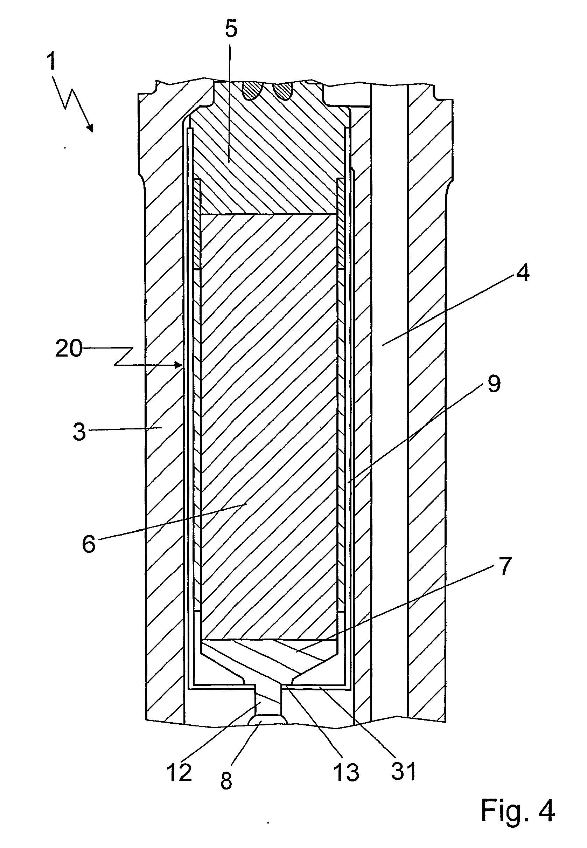

In Figur 4 ist ein drittes Beispiel eines nicht erfindungsgemäßen piezoelektrischen Aktormoduls 30 dargestellt. Diese Ausführungsform unterscheidet sich von derjenigen nach den Figuren 1 und 2 dadurch, daß sie eine Membran 31 aufweist, welche einstückig mit der Hülse 9 gefertigt ist und mithin mit der Hülse 9 eine Einheit bildet. Die Membran 31, die eine flache bzw. ebene Geometrie aufweist, ist ringförmig ausgebildet und an ihrer inneren Begrenzung über eine Schweißnaht 13 mit dem Aktorkopf 7 verbunden.

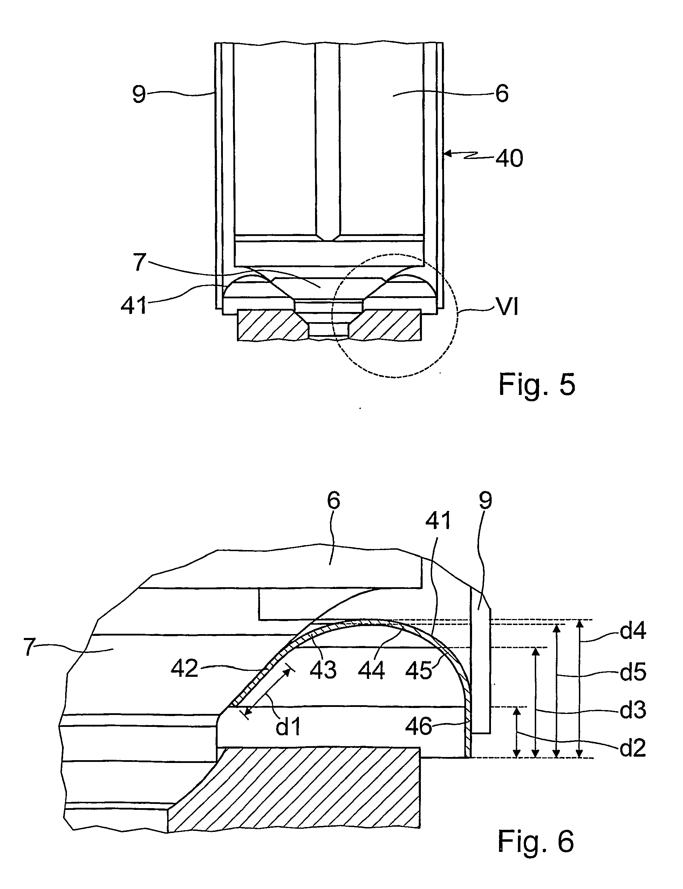

In Figur 5 ist eine erste erfindungsgemäße Ausführungsform eines piezoelektrischen Aktormoduls 40 dargestellt. Der Aufbau des Aktormoduls 40 unterscheidet sich von demjenigen des Aktormoduls nach Figur 1 dadurch, daß er eine Membran 41 aufweist, die einen Querschnitt mit unterschiedlichen Krümmungsradien aufweist, wobei die ringförmige Membran 41 in Richtung des piezoelektrischen Bauelements 6 gewölbt ausgebildet ist.

Der Querschnitt der Membran 41, der in Figur 6 vergrößert dargestellt ist, weist einen kegelförmig ausgebildeten, im Querschnitt ebenen Bereich 42 auf, der mit der Hülse 9 einen Winkel von 45° aufspannt und eine Länge d1 von 0,7 mm aufweist. Die Membran 41 ist über den kegelförmigen Bereich 42 mit dem Aktorfuß 7 verschweißt. An den Bereich 42 schließt sich ein Bereich 43 mit einem ersten Krümmungsradius von 1,9 mm an, an welchen sich ein Bereich 44 mit einem zweiten Krümmungsradius von 1,5 mm anschließt, an welchen sich wiederum ein Bereich 45 mit einem dritten Krümmungsradius von 1,0 mm anschließt. An den Bereich 45 mit dem dritten Krümmungsradius schließt sich wiederum ein im Querschnitt ebener, zylindrischer Bereich 46 an, über welchen die Membran 41 mit der Hülse 9 verschweißt ist. Der Bereich 46 der Membran 41, der eine Höhe d2 von 0,7 mm aufweist, steht gegenüber der Hülse 9 um 0,3 mm vor. Der Bereich 45 mit dem dritten Krümmungsradius erstreckt sich bis auf eine Membranhöhe von 1,5 mm, der Bereich 44 mit dem zweiten Krümmungsradius durchläuft den Scheitelpunkt der Membran 41 auf einer Höhe d4 von 1,8 mm und endet auf einer Höhe d5 von 1,78 mm. Der Bereich 43 mit dem ersten Krümmungsradius erstreckt sich von einer Membranhöhe von 1,25 mm bis zu einer Membranhöhe von 1,78 mm.

Der Außendurchmesser der Membran 41 beträgt 9,85 mm, der Innendurchmesser der Membran 41 beträgt 3,7 mm.

Die in den Figuren 5 und 6 dargestellte Membran wird derart montiert, daß zunächst der Aktorkopf 7 lastfrei mit dem Bereich 42 der Membran 41 verschweißt wird. Zur Einstellung des Mittelspannungsniveaus kann dann der Aktorkopf 7 mit einer Vorlast von 750 N, was einem Aktorweg von 19 µm entspricht, auf das piezoelektrische Bauelement 6 gedrückt werden, wobei der Bereich 46 der Membran 41 mit der Hülse 9 unter dieser Vorlast verschweißt wird.

Alternativ kann der Bereich 46 der Membran 41 gezielt vorverformt und in die Hülse 9 gedrückt werden und erst dann mit der Hülse 9 verschweißt werden.

Durch das Aufbringen der Vorspannung bei der Montage der Membran kann das Spannungsniveau im Betriebspunkt deutlich abgesenkt werden.

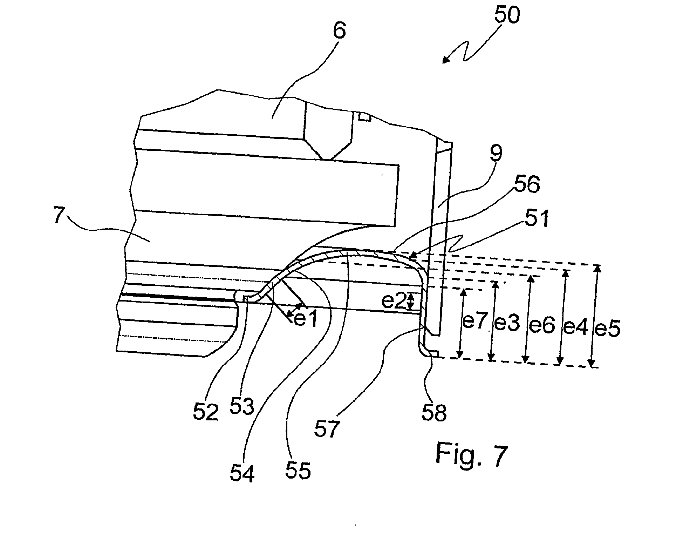

In Figur 7 ist eine zweite erfindungsgemäße Ausführungsform eines piezoelektrischen Aktormoduls 50 dargestellt. Der Aufbau des Aktormoduls 50 entspricht im wesentlichen demjenigen des Aktormoduls nach den Figuren 5 und 6, unterscheidet sich von diesem aber durch eine Membran 51 abweichender Geometrie.

Die Membran 51 ist in Richtung des piezoelektrischen Bauelementes 6 gewölbt ausgebildet und weist einen Querschnitt auf, der von einem rechtwinklig zur Achse des piezoelektrisches Bauelementes 6 ausgerichteten und den Aktorfuß umschließenden Ringbereich 52 gebildet ist, an den sich ein konischer Bereich 53 anschließt, in welchem die Membran 51 auf einer Länge e1 von etwa 0,3 mm mit dem Aktorfuß 7 verschweißt ist. An den konischen Bereich 53 schließt sich ein Bereich 54 mit einem ersten Krümmungsradius von 1,4 mm an, an welchen sich ein Bereich 55 mit einem zweiten Krümmungsradius von 2,47 mm anschließt, an welchen sich wiederum ein Bereich 56 mit einem dritten Krümmungsradius von 0,5 mm anschließt. An dem Bereich 56 mit dem dritten Krümmungsradius schließt sich wiederum ein im Querschnitt ebener, zylindrischer Bereich 57 an, über welchen die Membran 51 mit der Hülse 9 auf einer Länge e2 von etwa 0,3 mm verschweißt ist. Der-zylindrische Bereich 57 ist von einem schürzenförmigen, rechtwinklig zur Achse des piezoelektrischen Bauelementes 6 ausgerichteten Bereich 58 begrenzt. Der zylindrische Bereich 57 weist eine Höhe e3 von 1,2 mm auf und steht gegenüber der Hülse 9 vor. Der Bereich 56 mit dem dritten Krümmungsradius erstreckt sich bis auf eine Membranhöhe e4 von 1,75 mm, der Bereich 55 mit dem zweiten Krümmungsradius durchläuft den Scheitelpunkt der Membran 51 auf einer Höhe e5 von 1,85 mm und endet auf einer Höhe e6 von 1,62 mm. Der Bereich 54 mit dem ersten Krümmungsradius erstreckt sich von einer Membranhöhe von 1,24 mm bis zu einer Membranhöhe e7 von 1,66 mm.

Der Außendurchmesser der Membran 51 beträgt an dem schürzenförmigen Bereich 58 10,35 mm und an dem zylindrischen Bereich 57 9,89 mm. Der Innendurchmesser der Membran 51 beträgt 3,5 mm.

Wenngleich der beschriebene Einsatz des erfindungsgemäßen piezoelektrischen Aktormoduls bei einem Kraftstoff-Einspritzventil sehr vorteilhaft ist, so ist die Verwendung eines nach der Erfindung ausgestalteten piezoelektrischen Aktormoduls auch in anderen Anwendungsbereichen, insbesondere in Bereichen, in denen ein piezoelektrisches Bauelement vor Schmutz oder einem aggressiven Medium zu schützen ist, denkbar.

## Patentansprüche

1. Piezoelektrisches Aktormodul, zumindest umfassend ein piezoelektrisches Bauelement (6), einen Aktorfuß (5) und einen Aktorkopf (7), welcher mit einem von dem piezoelektrischen Bauelement (6) zu betätigenden Bauteil zusammenwirkt, wobei das Aktormodul (2; 20; 30; 40) von einer sich in axialer Richtung erstreckenden Hülse (9) umgeben ist und sich an den Aktorkopf (7) eine Membran (41; 51) anschließt, die sich im wesentlichen in radialer Richtung erstreckt, mit der Hülse (9) verbunden ist und einen Querschnitt mit unterschiedlichen Krümmungsradien aufweist,
**dadurch gekennzeichnet,**
**dass** die ringförmige Membran (41; 51) in Richtung des piezoelektrischen Bauelements (6) gewölbt ausgebildet ist und der Aktorkopf (7) einen konischen Abschnitt umfasst, an dem die Membran (41, 51) befestigt ist.

2. Piezoelektrisches Aktormodul nach Anspruch 1,
**dadurch gekennzeichnet,**
**dass** die Membran (41; 51) mit dem Aktorkopf (7) verschweißt ist.

3. Piezoelektrisches Aktormodul nach Anspruch 1 oder 2,
**dadurch gekennzeichnet,**
**dass** die Membran (41; 51) mit der Hülse (9) verschweißt ist.

4. Piezoelektrisches Aktormodul nach einem der Ansprüche 1 bis 3,
**dadurch gekennzeichnet,**
**dass** die Membran (41; 51) eine Dicke von zwischen etwa 70 µm und 200 µm aufweist.

5. Piezoelektrisches Aktormodul nach einem der Ansprüche 1 bis 4, **gekennzeichnet durch** seine Verwendung als Ansteuereinheit eines Kraftstoff-Einspritzventils (1), insbesondere eines Common-Rail-Einspritzventils, eines Kraftfahrzeugs.

6. Verfahren zur Montage eines piezoelektrischen Aktormoduls, das zumindest ein piezoelektrisches Bauelement (6), einen Aktorfuß (5) und einen Aktorkopf (7) umfasst, welcher mit einem von dem piezoelektrischen Bauelement (6) zu betätigenden Bauteil zusammenwirkt, wobei das Aktormodul (2; 20; 30; 40) von einer sich in axialer Richtung erstreckenden Hülse (9) umgeben ist und die Hülse (9) stirnseitig auf der Seite des Aktorkopfes (7) mittels einer Membran (41; 51) verschlossen wird, die sich im wesentlichen in radialer Richtung erstreckt,
**dadurch gekennzeichnet,**
**dass** die ringförmige Membran (41; 51) in Richtung des piezoelektrischen Bauelements (6) gewölbt ausgebildet wird und der Aktorkopf (7) mit einem konischen Abschnitt versehen wird, an dem die Membran (41, 51), die ebenfalls einen konischen Membranbereich (42, 53) besitzt, befestigt wird.

7. Verfahren nach Anspruch 6,
**dadurch gekennzeichnet,**
**dass** die Membran (41; 51) und der Aktorkopf (7) lastfrei verschweißt werden.

8. Verfahren nach Anspruch 7,
**dadurch gekennzeichnet,**
**dass** der mit der Membran (41; 51) verschweißte Aktorkopf (7) in die Hülse (9) eingeführt und in Richtung des piezoelektrischen Bauelements (6) mit einer Vorlast beaufschlagt wird.

9. Verfahren nach Anspruch 8,
**dadurch gekennzeichnet,**
**dass** die Membran (41; 51) bei vorbelastetem Aktorkopf (7) mit der Hülse (9) verschweißt wird.

## Claims

1. Piezoelectric actuator module, at least comprising a piezoelectric structural element (6), an actuator foot (5) and an actuator head (7) which cooperates with a component to be actuated by the piezoelectric structural element (6), the actuator module (2; 20; 30; 40) being surrounded by an axially extending sleeve (9), and the actuator head (7) having adjoining it, a diaphragm (41; 51) which extends essentially in the radial direction, is connected to the sleeve (9) and has a cross section with different radii of curvature, **characterized in that** the annular diaphragm (41; 51) is designed to be arched in the direction of the piezoelectric structural element (6), and the actuator head (7) comprises a conical portion to which the diaphragm (41, 51) is fastened.

2. Piezoelectric actuator module according to Claim 1, **characterized in that** the diaphragm (41; 51) is welded to the actuator head (7).

3. Piezoelectric actuator module according to Claim 1 or 2, **characterized in that** the diaphragm (41; 51) is welded to the sleeve (9).

4. Piezoelectric actuator module according to one of Claims 1 to 3, **characterized in that** the diaphragm (41; 51) has a thickness of between about 70 µm and 200 µm.

5. Piezoelectric actuator module according to one of Claims 1 to 4, **characterized by** its use as an activation unit of a fuel injection valve (1), in particular of a common-rail injection valve, of a motor vehicle.

6. Method for mounting a piezoelectric actuator module which comprises at least one piezoelectric structural element (6), an actuator foot (5) and an actuator head (7) which cooperates with a component to be actuated by the piezoelectric structural element (6), the actuator module (2; 20; 30; 40) being surrounded by an axially extending sleeve (9), and the sleeve (9) being closed on the end face, on the side of the actuator head (7), by means of a diaphragm (41; 51) which extends essentially in the radial direction, **characterized in that** the annular diaphragm (41; 51) is designed to be arched in the direction of the piezoelectric structural element (6), and the actuator head (7) is provided with a conical portion, to which the diaphragm (41, 51), which likewise possesses a conical diaphragm region (42, 53), is fastened.

7. Method according to Claim 6, **characterized in that** the diaphragm (41; 51) and the actuator head (7) are welded, load-free.

8. Method according to Claim 7, **characterized in that** the actuator head (7) welded to the diaphragm (41; 51) is introduced into the sleeve (9) and is acted upon in the direction of the piezoelectric structural element (6) by a preload.

9. Method according to Claim 8, **characterized in that**, with the actuator head (7) preloaded, the diaphragm (41; 51) is welded to the sleeve (9).

## Revendications

1. Module piézoélectrique d'actionnement, comprenant au moins un composant piézoélectrique (6), un pied d'actionneur (5) et une tête d'actionneur (7) qui coopère avec un composant qui doit être actionné par le composant piézoélectrique (6),
le module d'actionneur (2; 20; 30; 40) étant entouré par une douille (9) qui s'étend dans la direction axiale et une membrane (41; 51) qui s'étend essentiellement dans la direction radiale, qui est reliée à la douille (9) et dont la section transversale présente différents rayons de courbure se raccordant à la tête d'actionneur (7),
**caractérisé en ce que**
la membrane annulaire (41; 51) est bombée en direction du composant piézoélectrique (6) et la tête d'actionneur (7) comprend une partie conique sur laquelle la membrane (41; 51) est fixée.

2. Module piézoélectrique d'actionnement selon la revendication 1, **caractérisé en ce que** la membrane (41; 51) est soudée sur la tête d'actionneur (7).

3. Module piézoélectrique d'actionnement selon les revendications 1 ou 2, **caractérisé en ce que** la membrane (41; 51) est soudée sur la douille (9).

4. Module piézoélectrique d'actionnement selon l'une des revendications 1 à 3, **caractérisé en ce que** l'épaisseur de la membrane (41; 51) est comprise entre environ 70 µm et 200 µm.

5. Module piézoélectrique d'actionnement selon l'une des revendications 1 à 4, **caractérisé en ce qu'**il est utilisé comme unité d'entraînement d'une soupape (1) d'injection de carburant, en particulier d'une soupape d'injection à collecteur commun d'un véhicule automobile.

6. Procédé de montage d'un module piézoélectrique d'actionnement qui comprend au moins un composant piézoélectrique (6), un pied d'actionneur (5) et une tête d'actionneur (7) qui coopère avec un composant qui doit être actionné par le composant piézoélectrique (6),
le module d'actionneur (2; 20; 30; 40) étant entouré par une douille (9) qui s'étend dans la direction axiale et la douille (9) étant fermée frontalement sur le côté de la tête d'actionneur (7) au moyen d'une membrane (41; 51) qui s'étend essentiellement dans la direction radiale,
**caractérisé en ce que**
la membrane annulaire (41; 51) est bombée dans la direction du composant piézoélectrique (6) et la tête d'actionneur (7) est dotée d'une partie conique à laquelle est fixée la membrane (41; 51) qui possède également une partie conique (42; 53) de membrane.

7. Procédé selon la revendication 6, **caractérisé en ce que** la membrane (41; 51) et la tête d'actionneur (7) sont soudées hors charge.

8. Procédé selon la revendication 7, **caractérisé en ce que** la tête d'actionneur (7) soudée sur la membrane (41; 51) est insérée dans la douille (9) et est sollicitée par une pré-charge dans la direction du composant piézoélectrique (6).

9. Procédé selon la revendication 8, **caractérisé en ce que** la membrane (41; 51) est soudée sur la douille (9) lorsque la tête d'actionneur (7) est pré-chargée.
